# EUROPÄISCHE PATENTSCHRIFT

(11) **EP 1 425 241 B1**
(45) Veröffentlichungstag und Bekanntmachung des Hinweises auf die Patenterteilung: **27.11.2013**
(21) Anmeldenummer: 02754965.8
(22) Anmeldetag: 31.07.2002
(51) Int. Cl.: B81B 3/00, B81C 1/00

(54) **VERFAHREN ZUR HERSTELLUNG EINER MEMBRAN**
METHOD FOR THE PRODUCTION OF A MEMBRANE
PROCEDE DE PRODUCTION D'UNE MEMBRANE

(30) Priorität: 12.09.2001 DE 10144847
(43) Veröffentlichungstag der Anmeldung: 09.06.2004
(73) Patentinhaber: Infineon Technologies AG, 85579 Neubiberg (DE)
(72) Erfinder: AIGNER, Robert, 81675 München (DE); PLÖTZ, Florian, 81735 München (DE)
(74) Vertreter: Ginzel, Christian
(86) Internationale Anmeldenummer: PCT/EP2002/008553
(87) Internationale Veröffentlichungsnummer: WO 2003/022732

(56) Entgegenhaltungen:
- EP-A- 0 825 427
- EP-A- 1 041 629
- US-A- 5 998 816
- US-B1- 6 180 536
- US-B1- 6 250 165

## Beschreibung

Die vorliegende Erfindung betrifft ein Verfahren zur Herstellung einer Membran. Die vorliegende Erfindung betrifft insbesondere ein Verfahren zur Herstellung einer dielektrischen Membran.

Zur Steigerung der Leistungsfähigkeit von elektronischen Systemen und zur Kostenreduzierung ist es erstrebenswert, immer mehr Funktionen in einem einzigen Halbleiterprodukt zu integrieren. Dies führt in der Regel dazu, daß zusätzlich zu den Transistoren, Widerständen und Kondensatoren, aus denen üblicherweise die elektronischen System aufgebaut sind, weitere Baulelemente wie Spulen, akustische Filter, Sensoren, etc. in integrierter Weise auf einem Halbleitersubstrat hergestellt werden müssen. Während jedoch die Transistoren zu ihrer Herstellung bzw. Funktion üblicherweise ein Halbleitersubstrat benötigen, wirkt sich das Halbleitersubstrat oft negativ auf die Funktionsweise der zusätzlichen Bauelemente aus.

So werden beispielsweise integrierte Spulen derzeit in der Mehrzahl durch planare Spiralspulen realisiert, die üblicherweise auf der obersten Metallisierungsebene angeordnet sind. In der Regel bestehen die Spulen aus Metall (z.B. Al, AlSiCu, Cu), wodurch sie einen relativ niedrigen Leitungswiderstand aufweisen. Das Hauptproblem der planaren Spiralspulen liegt jedoch in der Richtung des magnetischen Flusses, da dieser, bedingt durch die Ausrichtung der Spiralspulen, zwangsläufig zu einem großen Teil durch das Halbleitersubstrat geführt wird. Je nach Substratleitwert treten dort parasitäre Wirbelstromeffekte auf, was sich inbesondere negativ auf die erzielbaren Güten der Spulen auswirkt. Darüber hinaus machen sich auch parasitäre Substratkapazitäten negativ auf die Funktionsweise der Spule bemerkbar.

Derartige negative Auswirkungen des Halbleitersubstrats ergeben sich nicht nur bei integrierten Spulen, sondern sie treten auch bei anderen Bauelementen wie Bulk-Acoustic-Wave-Bauelementen, IR-Sensoren, Chemosensoren und thermischen RF-Power-Sensoren auf. Bei den zuletzt genannten Sensor-Bauelementen machen sich insbesondere thermische Substratverluste negativ bemerkbar.

Zur Behebung dieser Schwierigkeiten hat man bisher versucht, durch Verwendung von hochohmigen Substraten oder sehr dicken Oxiden die Auswirkungen des Halbleitersubstrats zu begrenzen. Leider ist mit diesen Maßnahmen jedoch nur in Sonderfällen eine gewisse Verbesserung möglich. Darüber hinaus ergeben sich bei dieser Vorgesehensweise deutliche Einschränkung in der Integrationsfähigkeit mit den üblicherweise eingesetzten CMOS- oder HF-Bipolar-Prozessen.

Eine andere Möglichkeit, die genannten Schwierigkeiten zu beheben, ergibt sich aus der Verwendung von Membranen, an deren Unterseite das störende Halbleitersubstrat weitgehend entfernt ist. Zur Herstellung derartiger Membranen können eine Reihe von Verfahren eingesetzt werden. Die Herstellung von großflächigen dielektrischen Membranen durch eine Rückseitenätzung des Wafers (Bulk-Mikromechanik) ist beispielsweise eine Standardmethode, um Bereiche auf den Chips herzustellen, die gut thermisch isoliert sind. Leider sind diese Membranen in der Regel mechanisch sehr empfindlich und die Rückseitenöffnung erschwert die Montage. Darüber hinaus können derartige Membranen bisher nicht kompatibel zu Standard CMOS- oder Bipolarprozessen hergestellt werden und sie benötigen in der Regel spezielle und damit teure Packages.

In der Schrift US 6250165B1 wird ein weiteres Verfahren zur Herstellung von Membranen z.B. für Drucksensoren beschrieben, bei dem jedoch das Halbleitermaterial an der Unterseite der Oxidmembran als Sensor genutzt und daher nicht vollständig entfernt wird. Hierzu wird zunächst auf der Oberfläche eines Wafers, der aus einem, mit einer n-leitenden Epitaxischicht versehenen, p-leitenden Halbleitersubstrat besteht, ein Oxidfilm gebildet und erste Gräben bis in das p-leitende Halbleitersubstrat hinein erzeugt. Nachdem diese Gräben mit einem ersten dielektrischen Material, z.B. SiO₂, gefüllt wurden, wird der Oxidfilm vollständig von der Waferoberfläche entfernt und es wird ein thermischer Oxidfilm auf der Oberfläche des Wafers gebildet. Anschließend werden durch den thermischen Oxidfilm zweite Gräben erzeugt, die ebenfalls bis in das p-leitende Halbleitersubstrat hineinreichen. Danach erfolgt eine isotrope selektive Ätzung des p-leitenden Halbleitersubstrats bis zum ersten dielektrischen Material. Abschließend wird bei gegebenem Referenzdruck ein Versiegelungsfilm z.B. aus SiO₂ auf der gesamten Oberfläche des Wafers erzeugt, so daß eine leitfähige Membran gebildet wird, die an ihrer Unterseite aus einer strukturierten Schicht aus n-leitendem Halbleitermaterial besteht. Ändert sich der externe Druck wird diese leitfähige Membran deformiert, wodurch sich ihr Widerstand ändert. Eine Druckmessung kann daher über eine einfache Widerstandsmessung erfolgen.

Ein Verfahren bei dem ein Halbleitersubstrat bis zu vergrabenen Barrieren aus dielektrischen Materialen geätzt wird, ist zudem für Sensoren aus der US 5998816 und für mikrofluidische Systeme aus der US 6180436B1 bekannt. Dies kann bspw. der Schrift US 6180436B1 entnommen werden.

Der vorliegenden Erfindung liegt daher die Aufgabe zugrunde, ein Verfahren zur Herstellung von Membranen anzugeben, das die genannten Schwierigkeiten deutlich vermindert bzw. weitgehend vermeidet. Der vorliegenden Erfindung liegt insbesondere die Aufgabe zugrunde, ein Verfahren zur Herstellung von Membranen anzugeben, das weitgehend kompatibel zu Standard CMOS- oder Bipolarprozessen ist.

Diese Aufgabe wird von dem Verfahren zur Herstellung einer Membran gemäß dem unabhängigen Patentanspruch 1 gelöst. Weitere vorteilhafte Ausführungsformen, Ausgestaltungen und Aspekte der vorliegenden Erfindung ergeben sich aus den abhängigen Patentansprüchen, der Beschreibung und den beiliegenden Zeichnungen.

Erfindungsgemäß wird ein Verfahren zur Herstellung einer Membran bereitgestellt, das die folgenden Schritte umfaßt:
a) ein Halbleitersubstrat wird bereitgestellt,
b) in dem Halbleitersubstrat werden erste Gräben erzeugt,
c) zumindest ein erstes dielektrisches Material wird aufgebracht, so daß die Gräben mit dem ersten dielektrischen Material aufgefüllt werden und auf der Oberfläche des Halbleitersubstrats eine dielektrische Schicht gebildet wird,
d) in der dielektrischen Schicht werden Öffnungen erzeugt,
e) durch die Öffnungen in der dielektrischen Schicht wird eine isotrope Ätzung des Halbleitersubstrats selektiv zu dem ersten dielektrischen Material durchgeführt, und
f) zumindest ein zweites dielektrisches Material wird aufgebracht, so daß die Öffnungen der ersten dielektrischen Schicht verschlossen werden und eine Membran gebildet wird,
wobei die Breite der ersten Gräben kleiner als das Doppelte der Schichtdicke der dielektrischen Schicht gewählt ist.

Das erfindungsgemäße Verfahren besitzt den Vorteil, daß Membranen weitgehend kompatibel zu bestehenden CMOS-, BiCMOS bzw. Bipolarprozessen hergestellt werden können. Darüber hinaus stellen die so hergestellten Membranen keine erhöhten Anforderungen an die verwendeten Packages, so daß eine kostengünstige Herstellung des Gesamtsystems gewährleisten läßt. Insbesondere sind für die Herstellung der Membranstruktur nur 2 Lithographieschritte notwendig, was ebenfalls eine kostengünstige Herstellung gewährleistet.

Die fertige Membranstruktur enthält keine elektrisch oder thermisch gut leitfähigen Materialien. Da der Volumenanteil des ersten dielektrischen Materials unterhalb der Membran gering ist, können die im Zusammenhang mit dem Stand der Technik beschriebenen, von einem Halbleitersubstrat ausgehenden, negativen Einflüsse auf die Bauelemente, die auf der Membran angeordnet sind, weitgehend vermieden werden. So ergibt sich z.B. aus Sicht einer Spule, die auf der Membran angeordnet wird, das Verhalten einer relativ dicken "Schicht", die eine durchschnittliche relative Dielektrizitätszahl von ε < 2 aufweist, wobei gleichzeitig ohmsche Substratverluste minimiert werden können. In Strukturen, in denen das thermische Verhalten eine Rolle spielt, reduzieren sich die vertikalen Wärmeverluste auf den Querschnittsanteil der Stützen aus dielektrischen Material.

Gemäß einer bevorzugten Ausführungsform der erfindungsgemäßen Verfahrens ist die Tiefe der ersten Gräben größer ist als Tiefe der isotropen Ätzung in Schritt e), so daß eine gestützte Membranstruktur erzeugt werden kann.

Gemäß einer weiteren bevorzugten Ausführungsform der erfindungsgemäßen Verfahrens werden vor Schritt e) entsprechend den Öffnungen in der dielektrischen Schicht in dem Halbleitersubstrat zweite Gräben erzeugt, welche versetzt zu den ersten Gräben angeordnet sind. Dabei ist es insbesondere bevorzugt, wenn die zweiten Gräben eine geringere Tiefe als die ersten Gräben aufweisen.

Gemäß einer weiteren bevorzugten Ausführungsform der erfindungsgemäßen Verfahrens wird als erstes dielektrischen Material Siliziumoxid oder Siliziumnitrid verwendet. Weiterhin ist es bevorzugt, wenn als zweites dielektrisches Material BPSG (dotierstes Silikatglas) verwendet wird.

Gemäß einer weiteren bevorzugten Ausführungsform der erfindungsgemäßen Verfahrens ist die Tiefe der ersten Gräben größer 3 µm gewählt. Erfindungsgemäß wird die Breite der ersten Gräben kleiner als das Doppelte der Schichtdicke der dielektrischen Schicht gewählt. Dies hat zur Folge, daß die dielektrische Schicht auf der Substratoberfläche weitgehend planar erzeugt wird.

Gemäß einer weiteren bevorzugten Ausführungsform der erfindungsgemäßen Verfahrens wird als isotrope Ätzung in Schritt f) eine Naß- oder Trockenätzung eingesetzt. Dabei ist es bevorzugt, wenn eine plasmaunterstützte Trockenätzung, insbesondere eine plasmaunterstützte Trockenätzung auf der Basis von CF₄ und O₂ durchgeführt wird.

Die Erfindung wird nachfolgend anhand von Figuren der Zeichnung näher dargestellt. Es zeigen:
- Fig. 1 - 7: ein erfindungsgemäßes Verfahren zur Herstellung einer Membran,
- Fig. 8: ein erste Anordnung der ersten und zweiten Gräben in einer Aufsicht,
- Fig. 9: ein zweite Anordnung der ersten und zweiten Gräben in einer Aufsicht,
- Fig. 10: ein weitere Anordnung der ersten und zweiten Gräben in einer Aufsicht, und
- Fig. 11: ein weitere Anordnung der ersten und zweiten Gräben in einer Aufsicht.

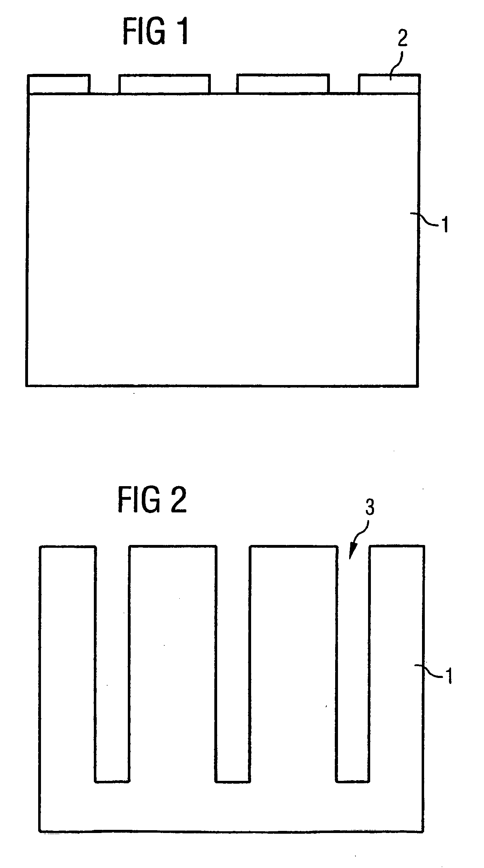

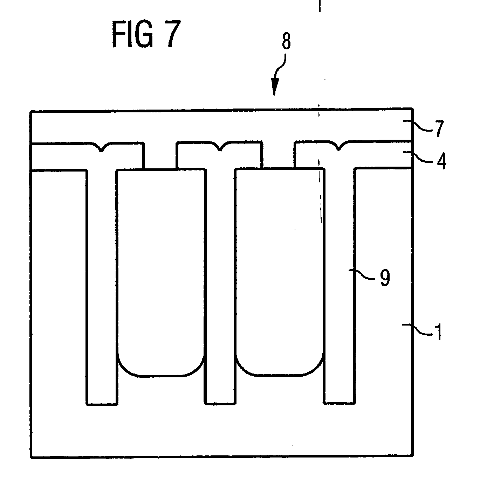

Die Figuren 1 bis 7 zeigen ein erfindungsgemäßes Verfahren zur Herstellung einer Membran auf einem Halbleitersubstrat.

Dazu wird in einem ersten Schritt ein Halbleitersubstrat 1, beispielsweise ein Siliumsubstrat, ein GaAs-Substrat oder ein SiC-Substrat, bereitgestellt. Auf das Halbleitersubstrat wird eine ersten Maskenschicht, beispielsweise eine Siliziumnitridschicht, gegenbenenfalls unter Verwendung einer dünnen Haftvermittlungsschicht, beispielsweise einer Siliziumoxidschicht, aufgebracht. Mit einer Phototechnik wird die erste Maskenschicht strukturiert, so daß eine strukturierte Hardmaske 2 für die nachfolgende Erzeugung der ersten Gräben gebildet wird. Die sich daraus ergebende Situation ist in Fig. 1 gezeigt.

Mit einem anisotropen Ätzverfahren werden entsprechend den Öffnungen in der Hardmaske 2 erste Gräben 3 in dem Halbleitersubstrat erzeugt. Die Tiefe der Gräben 3 ist dabei größer als 3 µm. Weiterhin ist die Breite der ersten Gräben 3 kleiner als das Doppelte der Schichtdicke der noch zu erzeugenden dielektrischen Schicht gewählt. Nachfolgend wird die Hardmaske 2 von der Oberfläche des Halbleitersubstrats entfernt, so daß sich die in Fig. 2 gezeigte Situation ergibt.

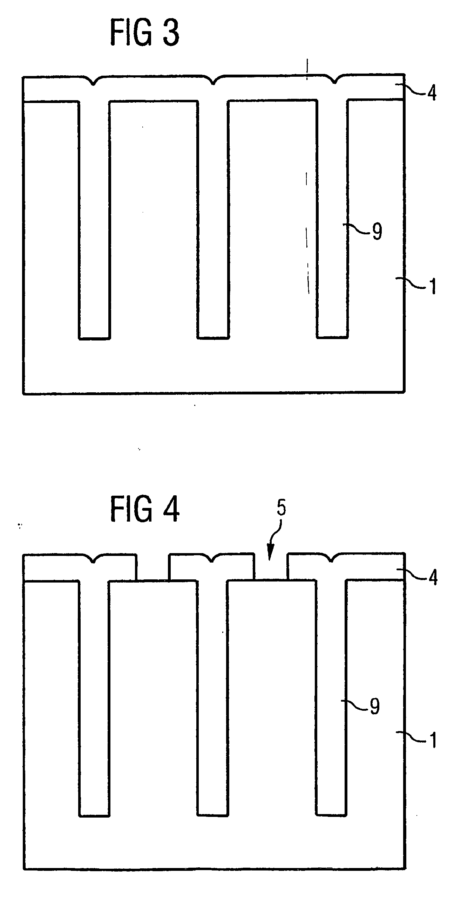

Anschließend wird ein erstes dielektrisches Material auf das Halbleitersubstrat 1 aufgebracht, so daß die Gräben 3 mit dem ersten dielektrischen Material aufgefüllt werden und auf der Oberfläche des Halbleitersubstrats 1 eine dielektrische Schicht 4 gebildet wird. Durch das Auffüllen der Gräben werden Stützen 9 für die spätere Membran gebildet. Da die Breite der ersten Gräben 3 kleiner als das Doppelte der Schichtdicke der dielektrischen Schicht 4 gewählt wurde, wird die dielektrische Schicht 1 auf der Substratoberfläche weitgehend planar erzeugt. Dabei wird als bevorzugtes dielektrisches Material Siliziumoxid eingesetzt, das beispielsweise mit einem TEOS-Verfahren (Tetraethylorthosilan) abgeschieden werden kann. Die sich daraus ergebende Situation ist in Fig. 3 gezeigt.

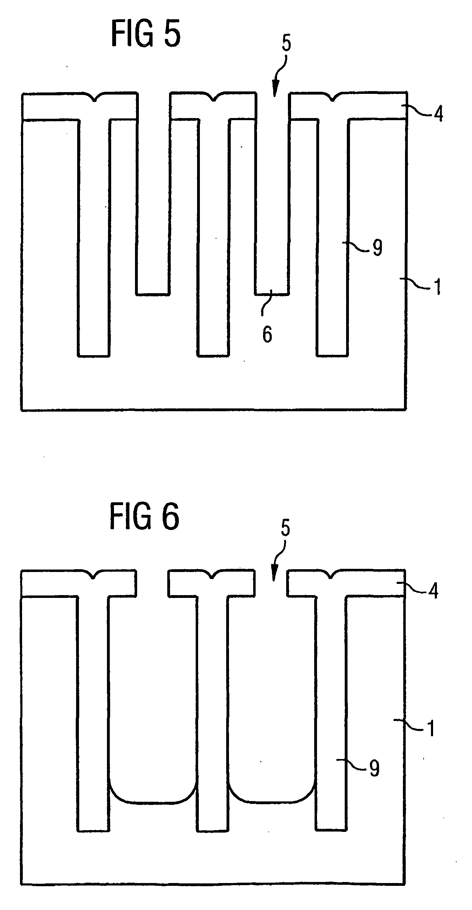

Nachfolgend werden mit Hilfe einer zweiten Phototechnik in der dielektrischen Schicht 4 Öffnungen 5 erzeugt, welche für eine isotrope Ätzung des Halbleitersubtrats 1 verwendet werden (Fig. 4). Zur besseren Kontrolle der isotropen Ätzung des Halbleitersubtrats 1 werden bevozugt vor der isotropen Ätzung zweite Gräben 6 in dem Halbleitersubstrat 1 erzeugt. Dabei ist es insbesondere bevorzugt, wenn die zweiten Gräben 6 eine geringere Tiefe als die ersten Gräben 3 aufweisen, da sich auf diese eine gestützte Membranstruktur erzeugen läßt. Die sich daraus ergebende Situation ist in Fig. 5 gezeigt.

Anschließend wird eine isotrope Naß- oder Trockenätzung des Halbleitersubstrats 1 selektiv zu dem ersten dielektrischen Material durchgeführt, so daß goße Hohlräume unterhalb der dielektrischen Schicht erzeugt werden (Fig. 6). Dabei ist es bevorzugt, wenn eine plasmaunterstützte Trockenätzung auf der Basis von CF₄ und O₂ durchgeführt wird. Die isotrope Ätzung wird so durchgeführt, daß die Ätztiefe geringer ist als die Tiefe der ersten Gräben 3. Dementsprechend wird die dielektrische Schicht 4 von dem ersten dielektrischen Material, mit dem die ersten Gräben 3 gefüllt sind, gestützt. Nachfolgend wird ein zweites dielektrisches Material 7 aufgebracht, so daß die öffnungen der ersten dielektrischen Schicht verschlossen werden und die Membran 8 vollständig ausgebildet ist. Bevorzugt wird dazu ein BPSG-Oxid ("Bor Phosphorous Silicat Glass") verwendet, das in dem Prozeßschritt, der bereits Teil eines CMOS-Planarisierungsprozesses sein kann, abgeschieden und durch Wärmebehandlung verflossen wird.

Die Anordnung sowie der Grundriss der ersten Gräben und damit der Stützen für die Membran kann je nach Anwendung gewählt werden. Insbesondere kann der Grundriss der Stützen als Säule oder Wand ausgeführt sein. Die Gestaltung der Stützen ist ein Kompromiss zwischen mechanischer Robustheit der Membran 8 und erzielbaren Verbesserungen hinsichtlich der Eigenschaften der Bauelemente, die über der Membran 8 angeordnet werden.

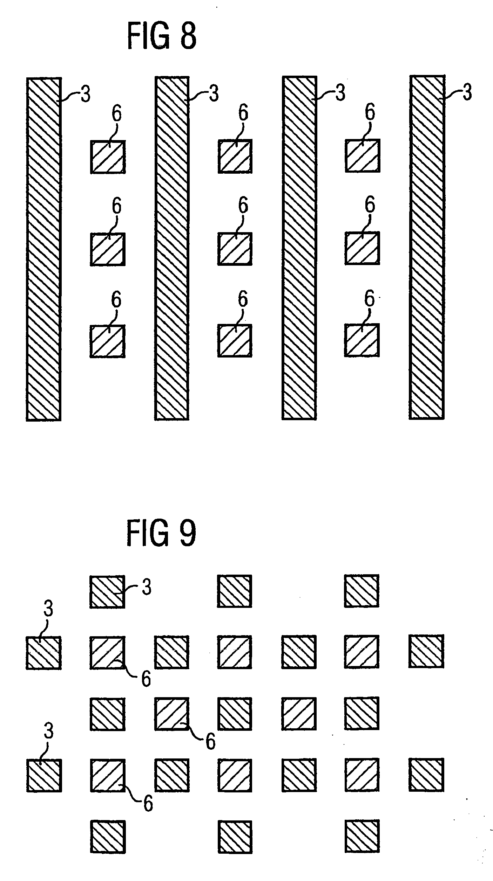

Fig. 8 zeigt ein erste Anordnung der ersten und zweiten Gräben in einer Aufsicht. Dieser Ausführungform weisen die ersten Gräben 3 eine langgezogene, rechteckige Form auf und dementsprechend sind die Stützen für die Membran 8 als rechteckige Wände ausgebildet. Die zweiten Gräben 6 sind isoliert zwischen den ersten Gräben 3 angeordnet.

Bei der in Fig. 9 gezeigten Ausführungsform sind die ersten Gräben 3 in einer Art Schachbrettmuster angeordnet. Dementsprechend sind die Stützen für die Membran 8 als Säulen ausgebildet.

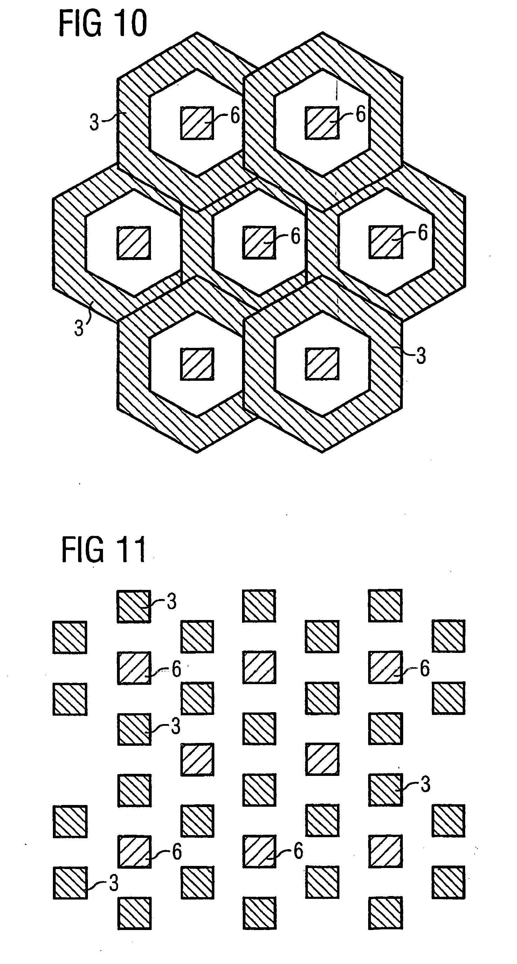

Fig. 10 zeigt ein weitere Anordnung der ersten und zweiten Gräben in einer Aufsicht. Dieser Ausführungform sind die ersten Gräben 3 in Form von Sechsecken in einer wabenförmigen Weise angeordnet. Dementsprechend sind die Stützen für die Membran 8 als wabenförmige Wände ausgebildet. Die zweiten Gräben 6 sind isoliert im Zentrum der Waben angeordnet.

Die in Fig. 11 gezeigte Ausführungsform entspricht weitgehend der Fig. 10 gezeigten Ausführungsform mit dem Unterschied, daß die Stützen für die Membran nicht als vollständige Wände sondern als isolierte Säulen in einer wabenförmigen Struktur angeordnet sind.

Das erfindungsgemäße Verfahren besitzt den Vorteil, daß Membranen weitgehend kompatibel zu bestehenden CMOS-, BiCMOS bzw. Bipolarprozessen hergestellt werden können. Darüber hinaus stellen die so hergestellten Membranen keine erhöhten Anforderungen an die verwendeten Packages, so daß eine kostengünstige Herstellung des Gesamtsystems gewährleisten läßt. Insbesondere sind für die Herstellung der gestützten Membranstruktur nur 2 Lithographieschritte notwendig, was ebenfalls eine kostengünstige Herstellung gewährleistet.

## Patentansprüche

1. Verfahren zur Herstellung einer Membran (8) auf einem Halbleitersubstrat (1) mit den Schritten:
a) ein Halbleitersubstrat (1) wird bereitgestellt,
b) in dem Halbleitersubstrat (1) werden erste Gräben (3) erzeugt,
c) zumindest ein erstes dielektrisches Material wird aufgebracht, so daß die ersten Gräben (3) mit dem ersten dielektrischen Material aufgefüllt werden und auf der Oberfläche des Halbleitersubstrats (1) eine dielektrische Schicht (4) gebildet wird,
d) in der dielektrischen Schicht (4) werden Öffnungen (5) erzeugt,
e) durch die Öffnungen (5) in der dielektrischen Schicht (4) wird eine isotrope Ätzung des Halbleitersubstrats (1) selektiv zu dem ersten dielektrischen Material durchgeführt, und
f) zumindest ein zweites dielektrisches Material (7) wird aufgebracht, so daß die Öffnungen (5) der ersten dielektrischen Schicht (4) verschlossen werden und eine Membran (8) gebildet wird
wobei die Breite der ersten Gräben (3) kleiner als das Doppelte der Schichtdicke der dielektrischen Schicht (4) gewählt ist.

2. Verfahren nach Anspruch 1,
**dadurch gekennzeichnet, daß** die Tiefe der ersten Gräben (3) größer ist als Tiefe der isotropen Ätzung in Schritt e).

3. Verfahren nach Anspruch 1 oder 2,
**dadurch gekennzeichnet, daß** vor Schritt e) entsprechend den Öffnungen (5) in der dielektrischen Schicht (4) in dem Halbleitersubstrat (1) zweite Gräben (6) erzeugt werden, welche versetzt zu den ersten Gräben (3) angeordnet sind.

4. Verfahren nach Anspruch 3,
**dadurch gekennzeichnet, daß** die zweiten Gräben (6) eine geringere Tiefe als die ersten Gräben (1) aufweisen.

5. Verfahren nach einem der vorherstehenden Ansprüche,
**dadurch gekennzeichnet, daß** als erstes dielektrischen Material Siliziumoxid oder Siliziumnitrid verwendet wird.

6. Verfahren nach einem der vorherstehenden Ansprüche,
**dadurch gekennzeichnet, daß** als zweites dielektrisches Material (7) BPSG verwendet wird.

7. Verfahren nach einem der vorherstehenden Ansprüche,
**dadurch gekennzeichnet, daß** die Tiefe der ersten Gräben (3) größer 3 µm gewählt ist.

8. Verfahren nach einem der vorherstehenden Ansprüche,
**dadurch gekennzeichnet, daß** als isotrope Ätzung in Schritt f) eine Naß- oder Trockenätzung eingesetzt wird.

## Claims

1. Method for producing a membrane (8) on a semiconductor substrate (1) comprising the following steps:
a) a semiconductor substrate (1) is provided,
b) first trenches (3) are produced in the semiconductor substrate (1),
c) at least one first dielectric material is applied, such that the first trenches (3) are filled with the first dielectric material and a dielectric layer (4) is formed on the surface of the semiconductor substrate (1),
d) openings (5) are produced in the dielectric layer (4),
e) an isotropic etch of the semiconductor substrate (1) selectively with respect to the first dielectric material is carried out through the openings (5) in the dielectric layer (4), and
f) at least one second dielectric material (7) is applied, such that the openings (5) of the first dielectric layer (4) are closed and a membrane (8) is formed,
wherein the width of the first trenches (3) is less than double the layer thickness of the dielectric layer (4).

2. Method according to Claim 1,
**characterized in that**
the depth of the first trenches (3) is greater than the depth of the isotropic etch in step e).

3. Method according to Claim 1 or 2,
**characterized in that**
before step e), in a manner corresponding to the openings (5) in the dielectric layer (4), second trenches (6) are produced in the semiconductor substrate (1), said second trenches being arranged in a manner offset with respect to the first trenches (3).

4. Method according to Claim 3,
**characterized in that**
the second trenches (6) have a smaller depth than the first trenches (1).

5. Method according to any of the preceding claims,
**characterized in that**
silicon oxide or silicon nitride is used as first dielectric material.

6. Method according to any of the preceding claims,
**characterized in that**
BPSG is used as second dielectric material (7).

7. Method according to any of the preceding claims,
**characterized in that**
the depth of the first trenches (3) is chosen to be greater than 3 µm.

8. Method according to any of the preceding claims,
**characterized in that**
a wet or dry etch is used as the isotropic etch in step f).

## Revendications

1. Procédé de production d'une membrane (8) sur un substrat (1) semi-conducteur comprenant les stades dans lesquels :
a) on se procure un substrat (1) semi-conducteur,
b) on produit des premiers sillons (3) dans le substrat (1) semi-conducteur,
c) on dépose au moins un premier matériau diélectrique de manière à remplir les premiers sillons (3) du premier matériau diélectrique et on forme une couche (4) diélectrique à la surface du substrat (1) semi-conducteur,
d) on produit des ouvertures (5) dans la couche diélectrique,
e) on effectue, à travers les ouvertures (5) de la couche (4) diélectrique, une attaque isotrope du substrat semi-conducteur sélectivement par rapport au premier matériau diélectrique et
f) on dépose au moins un deuxième matériau (7) diélectrique de manière à fermer les ouvertures (5) de la premier couche (4) diélectrique et de manière à former une membrane (8)
dans lequel on choisit la largeur des premiers sillons (3) plus petite que le double de l'épaisseur de la couche (4) diélectrique.

2. Procédé suivant la revendication 1,
**caractérisé en ce que**
la profondeur des premiers sillons (3) est plus grande que la profondeur de l'attaque isotrope dans le stade e).

3. Procédé suivant l'une des revendications 1 ou 2,
**caractérisé en ce que**
avant le stade e) on produit, conformément aux ouvertures (5) de la couche (4) diélectrique dans le substrat (1) semi-conducteur, des deuxièmes sillons (6) qui sont décalés par rapport aux premiers sillons (3).

4. Procédé suivant la revendication 3,
**caractérisé en ce que**
les deuxièmes sillons (6) ont une profondeur plus petite que les premiers sillons (3).

5. Procédé suivant l'une des revendications précédentes,
**caractérisé en ce que**
on utilise de l'oxyde de silicium ou du nitrure de silicium comme premier matériau diélectrique.

6. Procédé suivant l'une des revendications précédentes,
**caractérisé en ce que**
on utilise du verre au borophosphate de silicium comme deuxième matériau (7) diélectrique.

7. Procédé suivant l'une des revendications précédentes,
**caractérisé en ce que**
on choisit la profondeur des premiers sillons (3) plus grande que 3 µm.

8. Procédé suivant l'une des revendications précédentes,
**caractérisé en ce que**
on utilise comme attaque isotrope dans le stade f), une attaque en voie humide ou en voie sèche.
